# EUROPEAN PATENT SPECIFICATION

(11) **EP 3 031 310 B1**
(45) Date of publication and mention of the grant of the patent: **17.06.2020**
(21) Application number: 14749796.0
(22) Date of filing: 06.08.2014
(51) Int. Cl.: H05K 9/00

(54) **ELECTROMAGNETIC SHIELDING LAMINATE**
ELEKTROMAGNETISCH ABSCHIRMENDES LAMINAT
LAMINÉ POUR BLINDAGE ÉLECTROMAGNÉTIQUE

(30) Priority: 08.08.2013 NO 20131084
(43) Date of publication of application: 15.06.2016
(73) Proprietor: ROXAR FLOW MEASUREMENT AS, 4065 Stavanger (NO)
(72) Inventor: TORP, Michael, 3480 Fredensborg (DK)
(74) Representative: Protector IP AS
(86) International application number: PCT/EP2014/066902
(87) International publication number: WO 2015/018864

(56) References cited:
- US-A1- 2008 081 138
- US-A1- 2011 135 884
- US-B1- 8 104 519

## Description

The present invention relates to an electrically insulating flexible laminate for positioning inside a pipe having a known inner circumference comprising a conductive circuitry, especially an electrically conductive foil providing a Faraday cage in said pipe.

Specifically the invention relates to a concept for integration of a Faraday cage for shielding of electronics that has been invented to overcome technical issues in high temperature applications.

It is known that electronic systems circuitry in pipes may need electronic shielding in order to avoid noise or disturbances from the environment. Known system for shielding electronic circuitry inside a pipe consists of inserts in pipes where the inserts are made from pipe sections consisting of layers of electrically insulating and electrically conductive materials. Originally, in the present application, a Faraday cage shielding was provided by two double-sided, metal-clad laminates bonded together by an adhesive film. The adhesive film involved a material not suitable for high temperature applications, which added some unwanted risks to the shield integrity and to the enclosed assembly. The laminate size fits the length and the circumference of the assembly plus the required overlap to make the shield completely enclose the assembly. Thus there were problems both relating to the layered structure being vulnerable to the high temperature environment in the pipes, which may lead to disintegrating of the layered structure and thus ruining the protection, and to the adaptation of the device to the individual pipe dimensions. Examples of laminated films or sheets are discussed in US20009/0165296 and US2011/0135884, while a shielded flexible pipe is shown in JP2012104727A.

Thus it is an object of the present invention to provide a low cost and robust means for positioning an electrically conductive layer being insulated from pipe wall and pipe interior into a pipe, especially for obtaining a Faraday cage protecting an electronic circuitry inside the pipe. This is obtained as specified in the accompanying claims.

The present invention eliminates materials incompatible for high temperature long-term use. The construction can easily be designed and adapted to individual requirements and is not only advantageous in high temperature applications. The benefits of this shield construction are:
- The construction involves a minimum of materials; the metal shield and the insulating substrate. No adhesive is required.
- No adhesion between the layers reduces the mechanical stress induced by the bending.
- Good control of inner and outer insulation barriers by adjusting the number of layers/sections.
- Greater protection against mechanical wear and ripping during insertion.
- The thin construction is easier to apply/roll in production.
- The construction is more simple and cheaper to produce.

The invention will be described below with reference to the accompanying drawing, illustrating the invention by way of example.
- Fig. 1a-c: illustrates a first embodiment of the invention.
- Fig. 2a,b: illustrates a second embodiment of the invention.

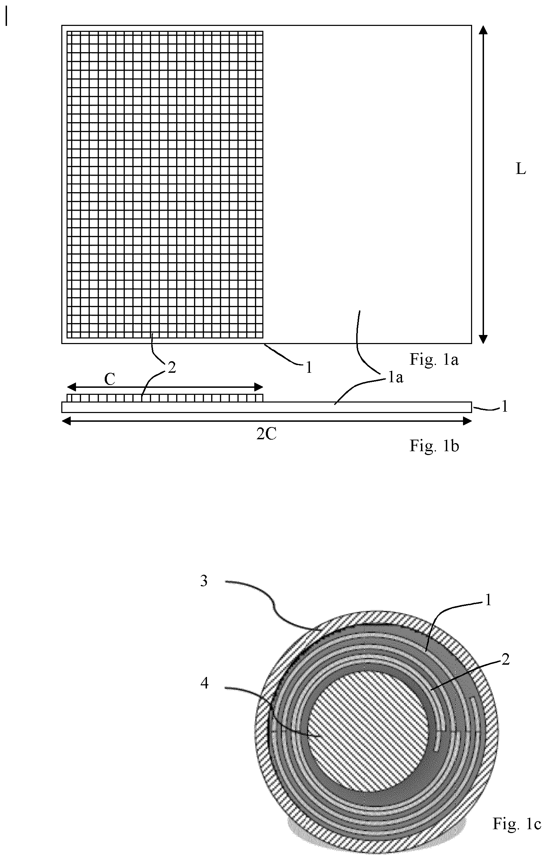

As illustrated in figure 1a-c the concept is visualized schematically, where the sizes are not necessarily to scale. Figures 1a and 1b illustrates the laminate seen from above and from a direction corresponding to the lower side of fig. 1a, respectively, and fig. 1c illustrates the present invention 1, 2 mounted between the pipe wall 3 and the instruments 4 inside the pipe. The invention comprises a laminate including a flexible substrate 1 or similar made from an insulating material. Part of the substrate is covered by an electrically conductive layer 2 being constituted by a foil forming a continuous layer, grid, circuitry or similar of conductive material depending on the use. In the preferred embodiment the layout of the conductive layer 2 is sufficiently dense to provide a Faraday cage when rolled and mounted into the pipe.

The length L of the conductive layer 2 in the first direction may depend on the use, e.g. depending on the dimensions of the circuitry inside to be shielded, and in the second direction the conductive layer essentially at least corresponds to the inner circumference C of the pipe 3. This way the conductive layer will surround a section of the pipe interior in a length L.

In order to insulate the conductive layer 2 the substrate extends at least two times the pipe circumference in the second direction. Thus, by rolling the laminate according to the invention the conductive layer may be positioned between the substrate on which it is bonded and the substrate not being provided with a conductive layer. Referring to figure 1b the laminate may thus be rolled from the right so as to enclose the conductive foil completely in insulating materials. This may then simply be inserted into the pipe as illustrated in fig. 1c.

The physical shield is thus designed using a flexible printed board rolled into a tubular shape enclosing the assembly containing the electronics to be protected. The construction provides an insulating layer on each side of the conductive shield layer that constitutes the Faraday cage. The outer insulating layer functions as an insulating barrier between the Faraday cage and the conductive pipe. The inner insulating layer functions as an insulating barrier between the Faraday cage and the enclosed assembly.

The new invention thus provides the same functionality as the previously used solution by achieving an improved functional construction without the problematic adhesive. The invention can by example be produced by the following process: A single double-sided, metal-clad laminate is processed into a single-sided laminate (by etching using standard printed board fabrication processes). One dimension of the single laminate is corresponding to an integer number of the circumference of the assembly (plus the required overlap). The laminate sheet is divided into sections, where a 'section' is defined as fully covering the circumference once. The construction is build by multiple steps of sections rolled over the assembly:
1. The first section contains the metal shield (typically copper) 2 bonded onto the substrate 1, which is rolled over the assembly providing an insulating layer against the enclosed assembly and exposing the shield on the outside.
2. The second section 1a is bare substrate, which is continued rolled over the exposed shield and thereby establishing an insulating layer against the outside consisting of a housing, pipe 3 etc.
3. Any consecutive sections of bare substrate are rolled over the assembly increasing the insulating layers incrementally improving the insulation barrier.
4. An additional section(s) of bare substrate can also function as a mechanical protective layer against scratches inflicted by for example the inner surface of the pipe.

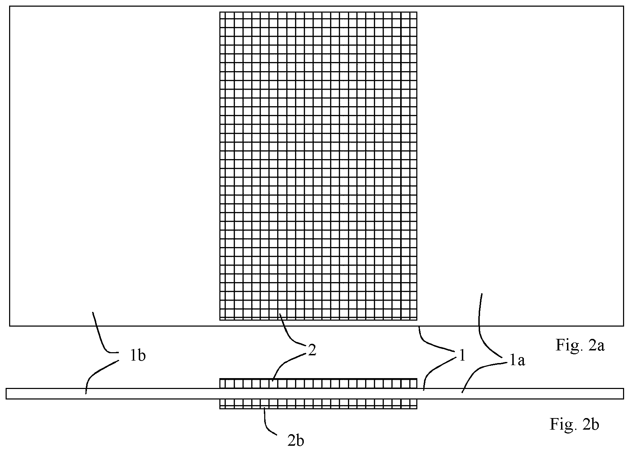

In figure 2a and 2b the laminate is provided with a bare substrate part 1a, 1b on each side of the conductive part. This way the roll direction does not affect the function of the laminate as the conductive layer will always be positioned between the first and second bare section. In addition figure 2b illustrates an additional conductive layer 2b on the other side of the substrate, thus increasing the robustness of the shield for any damages and/or improving the efficiency of the Faraday cage. One or both conductive layers may include circuitry and be connected through the insulating substrate 1.

To summarize the invention thus relates to an electrically insulating flexible laminate for positioning inside a pipe having a known inner circumference, e.g. a pipe prepared for containing electronic equipment at a known position or the pipe being adapted to contain electronic equipment being moved through a larger pipe. The laminate according to the invention has a first dimension extending a chosen length along the pipe and includes a first section comprising an electrically conductive area on a substrate or similar made by an electrically insulating material, and a second section being constituted only by the electrically insulating material. Both the first and second section has a second dimension perpendicular to the first at least exceeding said inner circumference of the pipe into which it is to be positioned. The second section thus being adapted to cover said first section when rolled over and positioned along the inner circumference of said pipe.

The conductive area on said first section extends along a length in the second direction constituting at least one circumference of the pipe, thus providing a space within the pipe enclosed by the conductive area providing a local Faraday cage inside said pipe. The first section is preferably constituted by a metal-clad substrate processed into a single-sided laminate, e.g. by etching using standard printed board fabrication processes, for example a metal layer is copper bonded to the substrate. The insulating material or substrate may be made from a flexible printed board, e.g. of a film composed by polyimide.

The present invention also relates to a shielded electronics unit providing an electronic shield for electronic equipment positioned in a pipe. The shield comprises a laminate as discussed above where the length of said conductive area in said first direction exceeding the length of the electronic equipment in the direction of the pipe, and in the second direction at least exceeds inner circumference of the pipe, the conductive material being adapted to provide a Faraday cage within said pipe.

## Claims

1. Insulating flexible laminate (1) for positioning inside a pipe having a known inner circumference, the laminate having a first dimension (L) extending a chosen length along the pipe, the laminate including a first section comprising an electrically conductive area (2) on an electrically insulating material and a second section (1a,b) being constituted by said insulating material,
**characterised in that** the first and second section each has a second dimension at least exceeding said inner circumference (C) of the pipe, the second section (1a) thus being adapted to cover said conductive area of said first section (2) when the flexible laminate (1) is rolled into a tubular shape and positioned along the inner circumference of said pipe, the conductive area thus being enclosed between insulating material on which it is bonded and the second section (1a), a when in said pipe, the conductive layer (2) being sufficiently dense to provide a Faraday cage when inserted into the pipe.

2. Laminate according to claim 1 wherein the conductive area on said first section extends along a length in the second direction constituting at least one circumference of the pipe

3. Laminate according to claim 1, wherein said first section is constituted by a metal-clad laminate processed into a single-sided laminate, e.g. by etching using standard printed board fabrication processes.

4. Laminate according to claim 3, wherein the metal layer is copper bonded to the substrate.

5. Laminate according to claim 1, wherein the insulating material is made from a flexible print board, e.g. of a film composed by polyimide.

6. Laminate according to claim 1 wherein the conductive area on said first section extends along a length in the first direction at least the same length as any electronics circuitry placed inside the pipe.

7. Shielded electronic unit comprising electronic equipment positioned in a pipe and a shield, the shield comprising a laminate according to claim 1, the length of said conductive area of said laminate in said first dimension exceeding the length of the electronic equipment in the direction of the pipe, and in the second dimension at least exceeding inner circumference of the pipe, the electrically conductive material being adapted to provide a Faraday cage within said pipe.

## Patentansprüche

1. Isolierendes flexibles Laminat (1) zur Anordnung innerhalb eines Rohrs mit einem bekannten Innenumfang, wobei das Laminat eine erste Abmessung (L) aufweist, die sich über eine gewählte Länge entlang des Rohrs erstreckt, wobei das Laminat einen ersten Abschnitt, der einen elektrisch leitenden Bereich (2) auf einem elektrisch isolierenden Material umfasst, und einen zweiten Abschnitt (1a, b), der durch das Isoliermaterial gebildet ist, aufweist,
**dadurch gekennzeichnet, dass** der erste und der zweite Abschnitt je eine zweite Abmessung aufweisen, die zumindest den Innenumfang (C) des Rohrs überschreitet, wobei der zweite Abschnitt (1a) dazu ausgelegt ist, den leitenden Bereich des ersten Abschnitts (2) zu bedecken, wenn das flexible Laminat (1) zu einer rohrförmige Form aufgerollt und entlang des Innenumfangs des Rohrs angeordnet ist, wobei der leitende Bereich somit zwischen dem Isoliermaterial, auf das er aufgeklebt ist, und dem zweiten Abschnitt (1a) eingeschlossen ist, wenn er sich in dem Rohr befindet, wobei die leitende Schicht (2) dicht genug ist, um einen Faraday'schen Käfig bereitzustellen, wenn sie in das Rohr eingeführt ist.

2. Laminat nach Anspruch 1, wobei sich der leitende Bereich auf dem ersten Abschnitt entlang einer Länge in der zweiten Richtung erstreckt, die mindestens den Umfang des Rohrs ausmacht.

3. Laminat nach Anspruch 1, wobei der erste Abschnitt durch ein metallkaschiertes Laminat gebildet ist, das zu einem einseitigen Laminat verarbeitet ist, z. B. durch Ätzen, wobei standardmäßige Leiterplatten-Herstellungsverfahren benutzt werden.

4. Laminat nach Anspruch 3, wobei die Metallschicht an das Substrat kupfergebondet ist.

5. Laminat nach Anspruch 1, wobei das Isoliermaterial aus einer flexiblen Druckplatte, z. B. aus einem aus Polyimid bestehenden Film, hergestellt ist.

6. Laminat nach Anspruch 1, wobei sich der leitende Bereich auf dem ersten Abschnitt entlang einer Länge in der ersten Richtung mindestens über die gleiche Länge wie etwaige im Inneren des Rohrs angeordnete elektronische Schaltungen erstreckt.

7. Abgeschirmte elektronische Einheit, umfassend eine in einem Rohr angeordnete elektronische Einrichtung und eine Abschirmung, wobei die Abschirmung ein Laminat nach Anspruch 1 umfasst, wobei die Länge des leitenden Bereichs des Laminats entlang der ersten Abmessung die Länge der elektronischen Einrichtung in Längsrichtung des Rohrs überschreitet und in der zweiten Abmessung zumindest den Innenumfang des Rohrs überschreitet, wobei das elektrisch leitende Material dazu ausgelegt ist, einen Faraday'schen Käfig innerhalb des Rohrs bereitzustellen.

## Revendications

1. Stratifié souple isolant (1) pour un positionnement à l'intérieur d'un tuyau ayant une circonférence intérieure connue, le stratifié ayant une première dimension (L) s'étendant sur une longueur choisie le long de la conduite, le stratifié comprenant une première section comprenant une zone électroconductrice (2) sur un matériau électriquement isolant et une seconde section (la, b) étant constituée par ledit matériau isolant,
**caractérisé en ce que** les première et seconde sections présentent chacune une seconde dimension au moins supérieure à ladite circonférence intérieure (C) du tuyau, la seconde section (1a) étant ainsi adaptée à recouvrir ladite zone conductrice de ladite première section (2) lorsque le stratifié souple (1) est roulé en une forme tubulaire et positionné le long de la circonférence intérieure dudit tuyau, la zone conductrice étant ainsi enfermée entre le matériau isolant auquel elle est liée et la seconde section (la), lorsque dans ledit tuyau, la couche conductrice (2) étant suffisamment dense pour fournir une cage de Faraday lorsqu'elle est insérée dans le tuyau.

2. Stratifié selon la revendication 1, dans lequel la zone conductrice sur ladite première section s'étend le long d'une longueur dans la seconde direction constituant au moins une circonférence du tuyau.

3. Stratifié selon la revendication 1, dans lequel ladite première section est constituée d'un stratifié revêtu de métal transformé en un stratifié simple face, par exemple par gravure à l'aide de procédés de fabrication de cartes imprimées standard.

4. Stratifié selon la revendication 3, dans lequel la couche métallique est en cuivre lié au substrat.

5. Stratifié selon la revendication 1, dans lequel le matériau isolant est fabriqué à partir d'un panneau d'impression flexible, par exemple d'un film composé de polyimide.

6. Stratifié selon la revendication 1, dans lequel la zone conductrice sur ladite première section s'étend sur une longueur dans la première direction, au moins la même longueur que tout circuit électronique placé à l'intérieur du tuyau.

7. Unité électronique blindée comprenant un équipement électronique positionné dans un tuyau et un blindage, le blindage comprenant un stratifié selon la revendication 1, la longueur de ladite zone conductrice dudit stratifié dans ladite première dimension dépassant la longueur de l'équipement électronique dans la direction du tuyau, et dans la seconde dimension au moins supérieure à la circonférence intérieure du tuyau, le matériau électroconducteur étant adapté pour fournir une cage de Faraday à l'intérieur dudit tuyau.
